# EUROPEAN PATENT APPLICATION

(11) **EP 4 521 592 A1**
(43) Date of publication of application: **12.03.2025**
(21) Application number: 24188793.4
(22) Date of filing: 16.07.2024
(51) Int. Cl.: H02J 7/00

(54) **METHOD AND APPARATUS FOR CONTROLLING CHARGING OF BATTERY PACK**

(30) Priority: 06.09.2023 KR 20230118547
(71) Applicant: SAMSUNG SDI CO., LTD., Giheung-gu Yongin-si, Gyeonggi-do 17084 (KR)
(72) Inventor: Seo, Youngdong, Yongin-si, Gyeonggi-do 17084 (KR)
(74) Representative: Gulde & Partner

(57) **Abstract**

A method of controlling charging of a battery pack, including determining, based on information on a plurality of battery modules included in the battery pack, whether a battery module is replaced or added in the battery pack, measuring a cell voltage of each battery cell included in each of the plurality of battery modules when it is determined that the battery module is replaced or added in the battery pack, identifying a maximum cell voltage value and a minimum cell voltage value from among measured cell voltages, and charging the battery pack by cyclically repeating constant current charging and constant voltage charging for the battery pack until a difference between the maximum cell voltage value and the minimum cell voltage value is less than or equal to a predetermined value.

## Description

### BACKGROUND

### 1. Field

A method and apparatus for controlling charging of a battery pack is disclosed.

### 2. Description of the Related Art

Recently, the demand for portable electronic products such as laptops, video cameras, and portable phones, has increased rapidly. As the development of energy storage batteries, robots, satellites, and electric vehicles is rapidly advancing, research on secondary batteries that are repeatedly chargeable and dischargeable has been actively pursued.

Battery packs including battery modules with secondary batteries occasionally malfunction, whereupon the corresponding battery module may be replaced. Or in a different scenario, a battery module may be additionally mounted on the battery pack for expansion of the battery module.

In both scenarios of replacement or expansion of the battery module, there might be a voltage difference between the existing battery module and the battery module newly mounted on the battery pack. Thus, an imbalance problem and over-charging may occur in some battery cells during charging of the battery pack.

### SUMMARY

The invention is defined by the appended claims. The description that follows is subjected to this limitation. Any disclosure lying outside the scope of said claims is only intended for illustrative as well as comparative purposes.

One aspect of the present disclosure is directed to a method of controlling charging of a battery pack, including determining, based on information on a plurality of battery modules included in the battery pack, whether a battery module is replaced or added in the battery pack (e.g. in a processor), measuring a cell voltage of each battery cell included in each of the plurality of battery modules when it is determined that the battery module is replaced or added in the battery pack (e.g. in a voltage measurement unit), identifying a maximum cell voltage value and a minimum cell voltage value from among measured cell voltages (e.g. in a processor), and charging the battery pack by cyclically repeating constant (electric) current charging and constant voltage charging for the battery pack until a difference between the maximum cell voltage value and the minimum cell voltage value is less than or equal to a predetermined value.

In a preferred implementation, the determining whether the battery module is replaced or added in the battery pack may comprise, at a time of battery management system (BMS) wakeup for the plurality of battery modules, comparing unique manufacturing information on the plurality of battery modules before and after battery management system wakeup.

In another preferred implementation, the determining whether the battery module is replaced or added in the battery pack may comprise determining whether the battery module is replaced or added in the battery pack by comparing a voltage of each battery module at a time of battery management system shutdown with a voltage of each battery module at the time of battery management system wakeup.

In another preferred implementation , the charging of the battery pack may comprise, when the maximum cell voltage value is equal to a predetermined cell reference voltage for the battery pack undergoing constant current charging, performing constant voltage charging for the battery pack with a voltage when the maximum cell voltage value is equal to the predetermined cell reference voltage.

In another preferred implementation, the charging of the battery pack may comprise performing the constant current charging for the battery pack undergoing constant voltage charging, when the maximum cell voltage value decreases from the predetermined cell reference voltage by a predetermined value or greater.

In another preferred implementation, the charging of the battery pack may comprise performing the constant current charging such that, as a number of cyclic repetitions of the constant current charging and constant voltage charging increases for the battery pack during the constant current charging, a current value decreases by a predetermined value.

Another aspect of the present disclosure is directed to a computer program stored on a recording medium to execute the above-described method on a computing device.

Another aspect of the present disclosure is directed to an apparatus for controlling charging of a battery pack, comprising a voltage measurement unit configured to measure a cell voltage of each battery cell included in (each of) a plurality of battery modules of the battery pack, a current measurement unit configured to measure a charging and discharging current of the battery pack, and a processor electrically connected to the voltage measurement unit and the current measurement unit to exchange signals, and the processor is configured to determine, based on information on the plurality of battery modules included in the battery pack, whether a battery module is replaced or added in the battery pack, the processor is further configured to obtain a cell voltage of each battery cell included in (each of) the plurality of battery modules when the battery module is replaced or added in the battery pack, the processor is further configured to identify a maximum cell voltage value and a minimum cell voltage value from among measured cell voltages, and the processor is further configured to cyclically repeating constant current charging an constant voltage charging for the battery pack until a difference between the maximum cell voltage value and the minimum cell voltage value is less than or equal to a predetermined value to charge the battery pack.

In an preferred embodiment, the processor may be further configured to determine, for the plurality of battery modules at a time of battery management system (BMS) wakeup, whether a battery module is replaced or added in the battery pack by comparing unique manufacturing information on the plurality of battery modules before and after battery management system wakeup.

In another preferred embodiment, the processor is further configured to determine whether the battery module is replaced or added in the battery pack by comparing a voltage of each battery module at a time of battery management system shutdown with a voltage of each battery module at a time of battery management system wakeup.

In another preferred embodiment, the processor may be further configured to perform the constant voltage charging for the battery pack with a voltage at a time at which the maximum cell voltage value is equal to the predetermined cell reference voltage, when the maximum cell voltage value is equal to a predetermined cell reference voltage for the battery pack undergoing constant current charging.

In another preferred embodiment, the processor is further configured to perform the constant current charging for the battery pack undergoing constant voltage charging when the maximum cell voltage value decreases from the predetermined cell reference voltage by a predetermined value or greater.

In another preferred embodiment, the processor is further configured to perform the constant current charging such that, as a number of cyclic repetitions of the constant current charging and constant voltage charging increases for the battery pack during the constant current charging, a current value decreases by a predetermined value.

Another aspect of the present disclosure relates to a computer program comprising instructions to cause the processor of at least one embodiment of the above-mentioned apparatus to executing execute the above-mentioned method.

Another aspect of the present disclosure relates to a computer-readable recording medium having stored thereon the above-mentioned computer program.

### BRIEF DESCRIPTION OF THE DRAWINGS

Aspects and features will become apparent to those of skill in the art by describing in detail exemplary embodiments with reference to the accompanying drawings in which:
FIG. 1 shows an example battery pack according to embodiments including a plurality of battery modules, a voltage management unit, a current measurement unit, a temperature measurement unit, a processor and a memory.
FIG. 2 is a flowchart illustrating a charging control method according to a preferred implementation of the present disclosure.
FIG. 3 shows a process of cyclically repeating constant current charging and constant voltage charging for a battery pack, when a difference between the maximum cell voltage value and the minimum cell voltage value satisfies a threshold value.
FIG. 4 shows a process of switching a charging scheme to constant current charging when the maximum cell voltage value changes from the predetermined cell reference voltage by a threshold amount.
FIG. 5 shows a process of switching the charging scheme to constant voltage charging when the maximum cell voltage value is equal to the predetermined cell reference voltage.
FIG. 6 shows a process of switching a charging scheme to constant current charging when the maximum cell voltage value changes from the predetermined cell reference voltage by a threshold amount.
FIG. 7 shows a process of switching the charging scheme to constant voltage charging when the maximum cell voltage value is equal to the predetermined cell reference voltage.

### DETAILED DESCRIPTION

Example embodiments and implementations will now be described in more detail hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

As used herein, the term "and/or" includes any and all combinations of one or more of the associated listed items, e.g., "A and/or B" would include A, B, or A and B. Expressions such as "at least one of," if preceding a list of elements, modify the entire list of elements and do not modify the individual elements of the list.

Hereinafter, various embodiments of the present disclosure will be described in detail with reference to the attached drawings to allow those of ordinary skill in the art to easily carry out the examples of the present disclosure. However, the technical spirit of the present disclosure may not be limited to the embodiments described herein because it may be transformed into various forms and implemented. In the description of the examples disclosed herein, the detailed description of the related known technology will be omitted if it is determined to obscure the subject matter of the technical spirit of the present disclosure. Identical or similar components will be given identical reference numerals and will not be repeatedly described.

Throughout the specification, if a component is "connected" to another component, it may include not only a case where they are "directly connected", but also a case where they are "indirectly connected" with another component therebetween. If a component is referred to as "includes" another component, it may mean that the component may further include still another component rather than excluding the still another component unless stated otherwise.

Some examples may be described with functional block configurations and various processing operations. Some or all of the functional blocks may be implemented with various numbers of hardware and/or software configurations. For example, the functional blocks of the present disclosure may be implemented by one or more microprocessors or circuit configurations for certain functions. The functional blocks of the present disclosure may be implemented with various programming or scripting languages. The functional blocks of the disclosure may be implemented as an algorithm executed on one or more processors. A function performed by a functional block of the present disclosure may be performed by a plurality of functional blocks, or functions performed by a plurality of functional blocks may be performed by one functional block in the present disclosure. Moreover, the disclosure may employ related art for electronic environment setting, signal processing, and/or data processing, etc.

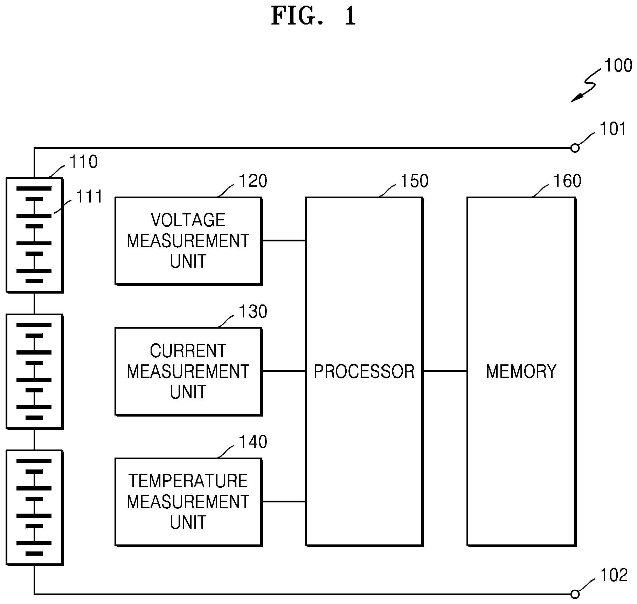

FIG. 1 shows a preferred embodiment of a battery pack including a plurality of battery modules, a voltage management unit, a current measurement unit, a temperature measurement unit, a processor and a memory. Referring to FIG. 1, a battery pack 100 may include a battery module 110, a processor 150, a memory 160, a voltage measurement unit 120, a current measurement unit 130, and a temperature measurement unit 140.

The battery module 110 may include a plurality of battery cells 111, each of which may be a chargeable secondary battery. For example, each battery cell 111 may comprise at least one selected from a group including a nickel-cadmium battery, a lead acid battery, a nickel metal hydride battery (NiMH), a lithium ion battery, and a lithium polymer battery.

A number of battery cells 111 included in the battery module 110 and a connection scheme thereof may be determined based on a power amount, or a voltage, required for the battery pack 100. Although it is shown in FIG. 1 that the battery cells 111 included in the battery module 110 are connected in series, the battery cells 111 may be connected in parallel, or in series and parallel. A plurality of battery modules 110 connected in series, in parallel, or in series and parallel may be included.

The battery pack 100 may include a plurality of battery modules 110, each of which includes a plurality of battery cells 111. The battery pack 100 may include a pair of pack terminals 101 and 102 to which an electrical load or a charging device may be connected.

The battery pack 100 according to embodiments of the present disclosure may include a switch. The switch may be connected between the battery module 110 and one (e.g., the pack terminal 101) of the pack terminals 101 and 102. The switch may be controlled by the processor 150. Although not shown in FIG. 1, the battery pack 100 may further comprise at least one of a battery protection circuit, a fuse, and a current sensor.

An apparatus for controlling charging of a battery pack according to embodiments of the present disclosure may comprise the processor 150 and the memory 160. For example, the processor 150 and the memory 160 may be included in a battery management system (BMS) of the battery pack 100.

The processor 150 may control an overall operation of the apparatus for controlling charging of a battery pack. For example, the processor 150 may be implemented into the apparatus for controlling charging of a battery pack and may comprise at least one selected from the group of a processor, an application-specific integrated circuit (ASIC), (another) a chipset, a logic circuit, a register, a communication modem, and a data processing device, and is configured to perform the above-described operation (method). The processor 150 may perform basic arithmetic, logic, and input/output operations, and execute program code stored in the memory 160. The processor 150 may store data in the memory 160 or load data stored in the memory 160.

The memory 160 may include a permanent mass storage device, such as random access memory (RAM), read only memory (ROM), and disk drive, as a recording medium readable by the processor 150. The memory 160 may store an operating system and at least one program or application code. The memory 160 may store program code for controlling charging of a battery pack. The memory 160 may store data generated in response to measuring at least one parameter during charging of the battery module 110. For example, the data may include charging/discharging current, terminal voltage and/or temperature of the battery. The memory 160 may store program code for estimating a state of charge (SoC) of the battery using the data, generated by measuring the at least one parameter of the battery module 110, and SoC-open circuit voltage (OCV) data. Parameters of the battery module 110 may refer to at least one variable such as a terminal voltage, a charging and discharging current, and an ambient temperature of the battery module 110.

The apparatus for controlling charging of the battery pack may further include the voltage measurement unit 120, the current measurement unit 130, and the temperature measurement unit 140 to measure at least one parameter of the battery module 110 or the battery cell 111. The apparatus for controlling charging of the battery pack may further include a communication module for communication with another device such as an electronic control device of a vehicle, a controller of a charging device.

The voltage measurement unit 120 may be configured to measure a voltage of the battery module 110. In addition, the voltage measurement unit 120 may be configured to measure a voltage of the battery cell 111. For example, as shown in a configuration of FIG. 1, the voltage measurement unit 120 may be electrically connected to opposite ends of the battery module 110 and/or the battery cell 111. The voltage measurement unit 120 may be electrically connected to the processor 150 to exchange electrical signals. The voltage measurement unit 120 may be configured to measure a voltage across the opposite ends of the battery module 110 and/or the battery cell 111 at time intervals and output a signal indicating a magnitude of the measured voltage to the processor 150, under control of the processor 150. The processor 150 may be configured to determine the voltage of the battery module 110 and/or the battery cell 111 from the signal output from the voltage measurement unit 120. For example, the voltage measurement unit 120 may comprise a voltage measurement circuit.

The current measurement unit 130 may be configured to measure the charging/discharging current of the battery pack 100. For example, as shown in the configuration of FIG. 1, the current measurement unit 130 may be electrically connected to a current sensor included in a charging/discharging path of the battery module 110 and/or the battery cell 111. The current measurement unit 130 may be electrically connected to the processor 150 to exchange electrical signals. The current measurement unit 130 may be configured to repeatedly measure a magnitude of charging current or discharging current of the battery module 110 and/or the battery cell 111 at time intervals and may be configured to output a signal indicating a magnitude of the measured current to the processor 150, under control of the processor 150. The processor 150 may be configured to determine the magnitude of the current from the signal output from the current measurement unit 130. For example, the current sensor may comprise a hall sensor or a sense resistor.

The temperature measurement unit 140 may be configured to measure the temperature of the battery. For example, as shown in the configuration of FIG. 1, the temperature measurement unit 140 may be connected to the battery module 110 and/or the battery cell 111 to measure a temperature of a secondary battery included in the battery module 110 and/or the battery cell 111. The temperature measurement unit 140 may be electrically connected to the processor 150 to exchange electrical signals. The temperature measurement unit 140 may be configured to repeatedly measure the temperature of the secondary battery at time intervals and may be configured to output a signal indicating a magnitude of the measured temperature to the processor 150. The processor 150 may be configured to determine the temperature of the secondary battery from the signal output from the temperature measurement unit 140. For example, the temperature measurement unit 140 may comprise a thermocouple.

The processor 150 may be configured to estimate a state of charge (SOC) of the battery module 110 by using at least one of a voltage measurement value, a current measurement value, and a temperature measurement value of the battery module 110, received from the voltage measurement unit 120, the current measurement unit 130, and the temperature measurement unit 140. Herein, the SOC may be calculated as a value corresponding to the remaining capacity of the battery module 110 in a range of 0 to 100 %.

The processor 150 may be electrically connected to the voltage measurement unit 120 and the current measurement unit 130 to exchange signals. The processor 150 may be configured to determine whether the battery module 110 is replaced or added in the battery pack 100, based on information on a plurality of battery modules 110 included in the battery pack 100. The processor 150 may be configured to obtain a cell voltage of each battery cell 111 included in the plurality of battery modules 110 if (when) the battery module 110 is replaced or added in the battery pack 100.

The processor 150 may be configured to identify a maximum cell voltage value and a minimum cell voltage value from among measured cell voltages, and cyclically repeat constant current charging and constant voltage charging for the battery pack 100 until a difference between the maximum cell voltage value and the minimum cell voltage value is less than or equal to a predetermined value (e.g. threshold). Herein, constant current charging may indicate a charging scheme in which a charging current of the battery pack 100 is supplied with a constant current. Constant voltage charging may indicate a charging scheme in which a charging voltage of the battery pack 100 is supplied with a constant voltage.

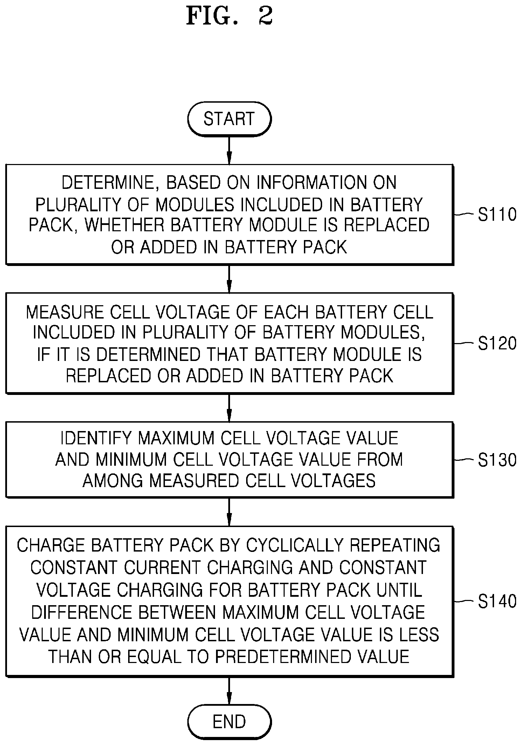

FIG. 2 is a flowchart showing an example charging control method. The method of controlling charging of a battery pack may be performed by the processor 150 shown in FIG. 1.

Referring to FIG. 2, in operation S110, the processor 150 may be configured to determine whether the battery module 110 is replaced or added in the battery pack 100, based on information on the plurality of battery modules 110 included in the battery pack 100. For example, in battery management system (BMS) wakeup, for the plurality of battery modules 110, the processor 150 may be configured to determine whether the battery module 110 is replaced or added in the battery pack 100 by comparing unique manufacturing information (e.g., a manufacturing date, serial number (S/N), a barcode) of the plurality of battery modules 110 before and after BMS wakeup. For example, the battery management system (BMS) may include the processor 150. The processor 150 may be configured to identify the replaced or added battery module 110 by comparing the unique manufacturing information on the plurality of battery modules 110 at the time of BMS shutdown with the unique manufacturing information on the plurality of battery modules 110 at the time of BMS wakeup. The information on the plurality of battery modules (unique manufacturing information) may comprise at least one of a manufacturing date, a serial number (S/N) and a barcode. Said information may be stored on a chip mounted on each of the plurality of battery modules 110 or may be visibly attached (e.g. printed or engraved) to each of the plurality of battery modules 110. The battery management system (BMS) including the processor 150 may further comprise means to read said chip or read the visibly attached information and the processor may be configured to identify the replaced or added battery module 110 by receiving the read information and comparing the information of the plurality of battery modules 110.

The processor 150 may be configured to determine whether the battery module 110 is replaced or added in the battery pack 100 by comparing a voltage of each battery module 110 at the time of the BMS shutdown with a voltage of each battery module 110 at the time of BMS wakeup. For example, the processor 150 may be configured to identify, as the replaced or added battery module 110, the battery module 110 in which the voltage thereof at the time of the BMS at the time of the BMS shutdown is different from the voltage thereof at the time of BMS wakeup.

In operation S120, the processor 150 may be configured to measure a cell voltage of each battery cell 111 included in the plurality of battery modules 110, if the battery module 110 is replaced or added in the battery pack 100.

In operation S130, the processor 150 may be configured to identify a maximum cell voltage value and a minimum cell voltage value from among measured cell voltages.

In operation S140, the processor 150 may be configured to charge the battery pack 100 by cyclically repeating constant current charging and constant voltage charging for the battery pack 100 until a difference between the maximum cell voltage value and the minimum cell voltage value is less than or equal to a predetermined value.

If the maximum cell voltage value is equal to a predetermined cell reference voltage for the battery pack 100 undergoing constant current charging, the processor 150 may be configured to perform constant voltage charging, for the battery pack 100, with a voltage at the time at which the maximum cell voltage value is equal to the predetermined cell reference voltage. For example, the processor 150 may be configured to switch constant current charging into constant voltage charging for the battery pack 100 undergoing constant current charging at the time at which the maximum cell voltage value is equal to the predetermined cell reference voltage.

The processor 150 may be configured to perform constant current charging for the battery pack 100 undergoing constant voltage charging, if the maximum cell voltage value decreases from the predetermined cell reference voltage by a predetermined value or greater. For example, the processor 150 may be configured to switch constant current charging into constant voltage charging for the battery pack 100 undergoing constant voltage charging at the time at which the maximum cell voltage value decreases from the predetermined cell reference voltage by the predetermined value or greater.

The processor 150 may be configured to perform constant current charging for the battery pack 100 undergoing constant current charging such that as the number of cyclic repetitions of constant current charging and constant voltage charging increases, the current value decreases by a predetermined value. For example, the processor 150 may be configured to perform constant current charging such that a following constant current charging current value is less than a previous constant current charging value by a predetermined value as the number of cyclic repetitions of constant current charging and constant voltage charging increases.

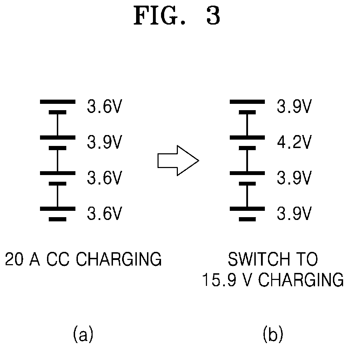

FIGS. 3 to 7 are views for describing a process of cyclically repeating constant current charging and constant voltage charging for a battery pack. Referring to FIGS. 3 to 7 four battery cells are serially connected.

FIG. 3 shows a process of performing constant current charging when a difference between the maximum cell voltage value and the minimum cell voltage value satisfies a threshold value. Referring to FIG. 3, if a battery module is replaced or added in the battery pack 100, the processor 150 may be configured to measure a cell voltage of each battery cell included in a plurality of battery modules and identify a maximum cell voltage value and a minimum cell voltage value from among measured cell voltages. For example, as shown in FIG. 3A, cell voltages of battery cells may be measured as 3.6 V, 3.9 V, 3.6 V, 3.6 V, respectively, a maximum cell voltage value may be identified as 3.9 V, and a minimum cell voltage value may be identified as 3.6 V

Next, the processor 150 may be configured to perform constant current charging if a difference between the maximum cell voltage value and the minimum cell voltage value is greater than or equal to a predetermined value. For example, as shown in FIG. 3A, if the difference between the maximum cell voltage value of 3.9 V and the minimum cell voltage value of 3.6 V is 0.3 V, constant current charging may be performed. For example, a predetermined value indicating the difference between the maximum cell voltage value and the minimum cell voltage value may be 0. For example, in initial constant current charging, constant current charging may start with an existing battery pack voltage. In this case, the initial constant current charging current may be 20 A.

The processor 150 may be configured to switch a charging scheme to constant voltage charging if the maximum cell voltage value is equal to the predetermined cell reference voltage. For example, as shown in FIG, 3B, if the maximum cell voltage value is equal to the predetermined cell reference voltage of 4.2 V, the processor 150 may switch the charging scheme from constant current charging into constant voltage charging. In this case, the charging voltage of the battery pack may be indicated as a sum of cell voltages of the battery cells. For example, referring to FIG. 3B, constant voltage charging may be performed with 15.9 V, that is a sum of battery cell voltages of 3.9 V, 4.2 V, 3.9 V, and 3.9 V

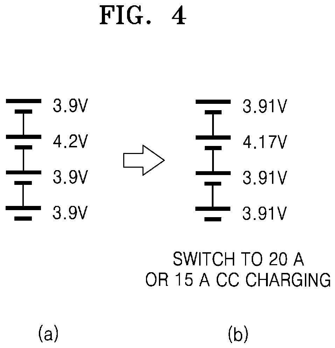

FIG. 4 shows a process of switching a charging scheme to constant current charging when the maximum cell voltage value changes from the predetermined cell reference voltage by a threshold amount. In an implementation, the processor 150 may be configured to switch a charging scheme to constant current charging if the maximum cell voltage value decreases from the predetermined cell reference voltage by a predetermined value or greater. For example, as shown in FIG. 4B, if the maximum cell voltage value decreases to 4.17 V from the predetermined cell reference voltage of 4.2 V by the predetermined value of 0.03 V or greater, constant current charging may be performed. In this case, constant current charging current may be an initial charging current of 20 A. The constant current charging current may be 15 A decreasing by 5 A from the charging current value of 20 A at the initial constant current charging stage.

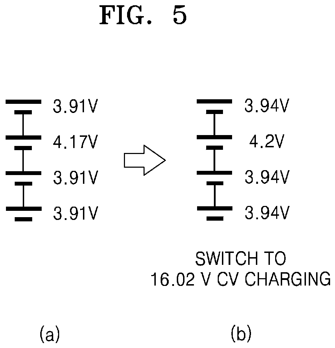

FIG. 5 shows a process of switching the charging scheme to constant voltage charging when the maximum cell voltage value is equal to the predetermined cell reference voltage. In an implementation, the processor 150 may switch the charging scheme to constant voltage charging if the maximum cell voltage value is equal to the predetermined cell reference voltage. For example, as shown in FIG, 5B, if the maximum cell voltage value is equal to the predetermined cell reference voltage of 4.2 V, the processor 150 may switch the charging scheme from constant current charging into constant voltage charging. In this case, the charging voltage of the battery pack may be indicated as a sum of cell voltages of the battery cells. For example, referring to FIG. 5B, constant voltage charging may be performed with 16.2 V that is a sum of battery cell voltages of 3.94 V, 4.2 V, 3.94 V, and 3.94 V

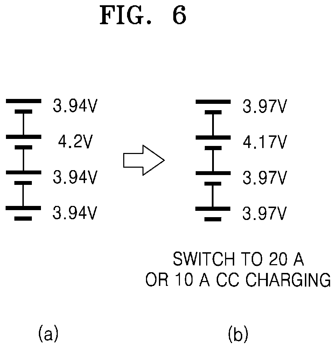

FIG. 6 shows a process of switching a charging scheme to constant current charging when the maximum cell voltage value changes from the predetermined cell reference voltage by a threshold amount. In an implementation, the processor 150 may be configured to switch a charging scheme to constant current charging if the maximum cell voltage value decreases from the predetermined cell reference voltage by a predetermined value or greater. For example, as shown in FIG. 6B, if the maximum cell voltage value decreases to 4.17 V from the predetermined cell reference voltage of 4.2 V by the predetermined value of 0.03 V or greater, constant current charging may be performed. In this case, constant current charging current may be an initial charging current of 20 A. Alternatively, the constant current charging current may be 10 A decreasing by 5 A from the charging current value of 15 A at the immediately previous constant current charging stage.

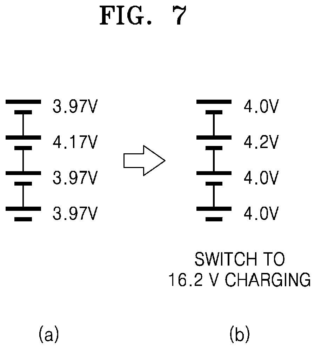

FIG. 7 shows a process of switching the charging scheme to constant voltage charging when the maximum cell voltage value is equal to the predetermined cell reference voltage. In an implementation, the processor 150 may be configured to switch the charging scheme to constant voltage charging if the maximum cell voltage value is equal to the predetermined cell reference voltage. For example, as shown in FIG, 7B, if the maximum cell voltage value is equal to the predetermined cell reference voltage of 4.2 V, the processor 150 may switch the charging scheme from constant current charging into constant voltage charging. In this case, the charging voltage of the battery pack may be indicated as a sum of cell voltages of the battery cells. For example, referring to FIG. 7B, constant voltage charging may be performed with 16.2 V that is a sum of battery cell voltages of 4.0 V, 4.2 V, 4.0 V, and 4.0 V

The processor 150 may be configured to cyclically repeat constant current charging and constant voltage charging until the difference between the maximum cell voltage value and the minimum cell voltage value converges to the predetermined value or less. For example, the processor 150 may be configured to cyclically repeat constant current charging and constant voltage charging until the maximum cell voltage value and the minimum cell voltage value converges to 0.

The processor 150 may be configured to set a current value in next constant current charging to be less than the current value in the initial constant current charging by the predetermined value. For example, referring to FIGS. 3 to 7, the processor 150 may be configured to set a charging current in first constant current charging to be 20 A, a charging current in second constant current charging to be 15 A, and a charging current in third constant current charging to be 10 A.

By way of summation and review, in the case of a battery pack including battery modules including such secondary batteries, if one battery module in use in the battery pack malfunctions, the corresponding battery module may be replaced. In addition, for expansion of the battery module, a battery module may be additionally mounted on the battery pack.

As such, during replacement or expansion of the battery module, if a voltage difference between an existing battery module and a battery module newly mounted on the battery pack is large, an imbalance problem may occur and over-charging may occur in some battery cells during charging of the battery pack. If the battery module is replaced or expanded, imbalance may be solved through charging control, thereby securing a capacity of the pack and protecting the pack from over-charging.

Moreover, conventionally, if the battery module during use thereof is replaced or expanded, the battery module is not fully charged and is likely to be over-charged due to imbalance. However, when the proposed charging control method according to the present disclosure is used, the imbalance may be solved and capacity may be secured due to a possibility of charging, and over-charging may be prevented.

The various embodiments described above are illustrative and are not to be independently implemented separately from each other. Embodiments described herein may be implemented in combination with each other.

Various embodiments of the present disclosure may be implemented in the form of a computer program executable on a computer through various components, and the computer program may be recorded on a computer-readable medium. The medium may continuously store an executable program or temporarily store the same for execution or downloading. The medium may include various recording means or storage means in a form of single hardware or a combination of several hardware, and may be distributed over a network without being limited to a medium directly connected to a certain computer system. Examples of the medium may include a magnetic medium such as a hard disk, a floppy disk, and a magnetic tape, an optical recording medium such as a CD-ROM and a DVD, a magneto-optical medium such as a floptical disk, ROM, RAM, flash memory, etc., to store a program instruction. Other examples of the medium may include a recording medium or a storage medium managed by an app store that distributes applications, a site that supplies or distributes various software, a server, etc.

In the specification, the term "unit", "module", etc., may be a hardware component like a processor or a circuit, and/or a software component executed by a hardware component like a processor. For example, "unit", "module", etc., may be implemented by components such as software components, object-oriented software components, class components, and task components, processes, functions, properties, procedures, subroutines, segments of program code, drivers, firmware, microcode, circuits, data, a database, data structures, tables, arrays, and variables.

Those of ordinary skill in the art to which the present disclosure pertains will appreciate that the present disclosure may be implemented in different detailed ways without departing from the technical spirit or essential characteristics of the present disclosure. Accordingly, the aforementioned embodiments should be construed as being only illustrative, but should not be constructed as being restrictive from all aspects. For example, each element described as a single type may be implemented in a distributed manner, and likewise, elements described as being distributed may be implemented as a coupled type.

The scope of the present disclosure is defined by the following claims rather than the detailed description, and the meanings and scope of the claims and all changes or modified forms derived from their equivalents should be construed as falling within the scope of the present disclosure.

According to the present disclosure, a charging control method, an apparatus, a computer program, and a computer-readable recording medium may be provided in which if the battery module is replaced or expanded, charging of the battery pack may be effectively controlled in a process of controlling charging of the battery pack. However, the scope of the present disclosure is not limited by these effects.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A method of controlling charging of a battery pack (100), the method comprising:
determining, based on information on a plurality of battery modules (110) included in the battery pack (100), whether a battery module (110) is replaced or added in the battery pack (100);
measuring a cell voltage of each battery cell (111) included in each of the plurality of battery modules (110) when it is determined that the battery module (110) is replaced or added in the battery pack (100);
identifying a maximum cell voltage value and a minimum cell voltage value from among measured cell voltages; and
charging the battery pack (100) by cyclically repeating constant current charging and constant voltage charging for the battery pack (100) until a difference between the maximum cell voltage value and the minimum cell voltage value is less than or equal to a predetermined value.

2. The method as claimed in claim 1, wherein determining whether the battery module (110) is replaced or added in the battery pack (100) comprises:
at a time of a battery management system wakeup for the plurality of battery modules (110), comparing the information on the plurality of battery modules (110) before and after the battery management system wakeup.

3. The method as claimed in claim 1 or 2, wherein determining whether the battery module (110) is replaced or added in the battery pack (100) comprises:
comparing a voltage of each battery module (110) at a time of a battery management system shutdown with a voltage of each battery module (110) at the time of a battery management system wakeup.

4. The method as claimed in one of the preceding claims, wherein the charging of the battery pack (100) comprises:
when the maximum cell voltage value is equal to a predetermined cell reference voltage for the battery pack (100) undergoing constant current charging, performing constant voltage charging for the battery pack (100) with a voltage when the maximum cell voltage value is equal to the predetermined cell reference voltage.

5. The method as claimed in claim 4, wherein the charging of the battery pack (100) comprises:
performing constant current charging for the battery pack (100) undergoing constant voltage charging, when the maximum cell voltage value decreases from the predetermined cell reference voltage by a predetermined value or greater.

6. The method as claimed in claim 5, wherein the charging of the battery pack (100) comprises;
performing the constant current charging such that, as a number of cyclic repetitions of the constant current charging and constant voltage charging increases for the battery pack (100) during the constant current charging, a current value decreases by a predetermined value.

7. An apparatus for controlling charging of a battery pack (100), the apparatus comprising:
a voltage measurement unit (120) configured to measure a cell voltage of each battery cell (111) included in each of a plurality of battery modules (110) of the battery pack (100);
a current measurement unit (130) configured to measure a charging and discharging current of the battery pack (100); and
a processor (150) electrically connected to the voltage measurement unit (120) and the current measurement unit (130) to exchange signals, wherein the processor (150) is configured to:
determine, based on information on the plurality of battery modules (110) included in the battery pack (100), whether a battery module (110) is replaced or added in the battery pack (100),
obtain a cell voltage of each battery cell (111) included in each of the plurality of battery modules (110) when the battery module (110) is replaced or added in the battery pack (100),
identify a maximum cell voltage value and a minimum cell voltage value from among measured cell voltages, and
cyclically repeating constant current charging and constant voltage charging for the battery pack (100) until a difference between the maximum cell voltage value and the minimum cell voltage value is less than or equal to a predetermined value to charge the battery pack (100).

8. The apparatus as claimed in claim 7, wherein the processor (150) is further configured to:
determine, for the plurality of battery modules (110) at a time of a battery management system wakeup, whether a battery module (110) is replaced or added in the battery pack (100) by comparing the information on the plurality of battery modules (110) before and after the battery management system wakeup.

9. The apparatus as claimed in one of claims 7 and 8, wherein the processor (150) is further configured to:
determine whether the battery module (110) is replaced or added in the battery pack (100) by comparing a voltage of each battery module (110) at a time of a battery management system shutdown with a voltage of each battery module (110) at a time of a battery management system wakeup.

10. The apparatus as claimed in at least one of claims 7 to 9, wherein the processor (150) is further configured to:
perform the constant voltage charging for the battery pack (100) with a voltage at a time at which the maximum cell voltage value is equal to the predetermined cell reference voltage, when the maximum cell voltage value is equal to a predetermined cell reference voltage for the battery pack (100) undergoing constant current charging.

11. The apparatus as claimed in claim 10, wherein the processor (150) is further configured to:
perform the constant current charging for the battery pack (100) undergoing constant voltage charging when the maximum cell voltage value decreases from the predetermined cell reference voltage by a predetermined value or greater.

12. The apparatus as claimed in claim 11, wherein the processor (150) is further configured to:
perform the constant current charging such that, as a number of cyclic repetitions of the constant current charging and constant voltage charging increases for the battery pack (100) during the constant current charging, a current value decreases by a predetermined value.

13. A computer program comprising instructions to cause the apparatus of one of claims 7 to 12 to execute the method according to at least one of claims 1 to 6.

14. A computer-readable recording medium having stored thereon the computer program of claim 13.
